**Europäisches Patentamt**

**European Patent Office**

**Office européen des brevets**

(19)

(11) Veröffentlichungsnummer: **0 009 152**
**B1**

(12) **EUROPÄISCHE PATENTSCHRIFT**

(45) Veröffentlichungstag der Patentschrift:
**04.11.81**

(21) Anmeldenummer: **79103225.3**

(22) Anmeldetag: **31.08.79**

(51) Int. Cl.³: **H 01 L 23/32, H 01 L 29/74**

54 **Steuerbares Leistungs-Halbleiterbauelement.**

(30) Priorität: **16.09.78 DE 2840400**

(43) Veröffentlichungstag der Anmeldung:
**02.04.80 Patentblatt 80/7**

(45) Bekanntmachung des Hinweises auf die Patenterteilung:
**04.11.81 Patentblatt 81/44**

(84) Benannte Vertragsstaaten:
**CH FR GB IT NL**

(56) Entgegenhaltungen:
**DE-A-2 021 158**
**DE-A1-224 642 3**
**DE-B2-240 593 0**
**GB-A-1 130 736**

(73) Patentinhaber: **BROWN, BOVERI & CIE**
**Aktiengesellschaft Mannheim, Kallstadter Strasse 1,**
**D-6800 Mannheim Käfertal (DE)**

(72) Erfinder: **Eisele, Dieter, Dipl.-Phys., Edisonstrasse 10,**
**D-6840 Lampertheim (DE)**

## Steuerbares Leistungs-Halbleiterbauelement

Die Erfindung bezieht sich auf ein steuerbares Leistungs-Halbleiterbauelement mit einem scheibenförmigen Siliziumkörper, an dessen jede Hauptoberfläche sich zwecks Druckkontaktierung eine duktile Elektrode und nachfolgend eine Druckkontaktscheibe aus Molybdän oder Wolfram anschließen, wobei mindestens ein Steuerelektrodenanschluß isoliert durch eine duktile Elektrode und eine Druckkontaktscheibe geführt ist und mit einem flachen, kreisringförmigen Käfig aus Isoliermaterial, der Siliziumkörper und Druckkontaktscheiben zentriert.

Bevorzugt handelt es sich um Leistungs-Thyristoren für Ströme bis zu einigen 1000 A, höchstzulässige, periodische Spitzensperrspannungen in Vorwärts- sowie in Rückwärtsrichtung bis zu einigen 1000 V und für Frequenzen bis mindestens 1500 Hz. Die Erfindung kann jedoch auch Anwendung finden bei bidirektional von einem Zustand niedrigen Widerstands in einen Zustand höheren Widerstands schaltbaren steuerbaren Leistungs-Halbleiterbauelementen, z. B. Triacs und voneinander völlig unabhängigen, in einen gemeinsamen Halbleiterkörper integrierten steuerbaren Leistungs-Halbleiterbauelementen, die zwei Steuerelektrodenanschlüsse aufweisen, die auf einer Seite des Halbleiterbauelementes oder auf verschiedenen Seiten desselben herausgeführt sind.

Bei einem bekannten druckkontaktierten Halbleiterbauelement der eingangs genannten Gattung ist der scheibenförmige Halbleiterkörper zwischen zwei napfförmige Silberelektroden eingelegt, die Napfränder sind den Hauptoberflächen (Scheibenflächen) abgewandt und umfassen die Druckkontaktkörper (DE-PS 2 039 806). Randseitig wird diese Anordnung von einem an sich bekannten Isoliergehäuse, z. B. aus Keramik, umschlossen (Brown Boveri Mitteilungen 5—75, Seite 225; DE-OS 2 246 423; DE-AS 2 405 930). Aus den letztgenannten beiden Schriften ist auch die Anordnung der Steuerelektrode in Form eines Zentralgates mit isolierter Herausführung bekannt, wie sie als zum gattungsbildenden steuerbaren Leistungs-Halbleiterbauelement gehörend vorausgesetzt wird. — Selbstverständlich ist diese Anordnung erst bei Aufbringen des Druckes mittels einer äußeren bekannten Spannvorrichtung thermisch und elektrisch leitfähig (BBC-Druckschrift Nr. D HS 70 467 D von 1977 »Kühlung und Montage von Leistungs-Halbleiterbauelementen«).

Der Sandwich-Aufbau aus Halbleiterkörper, zwei duktilen Silberelektroden und zwei Druckkontaktscheiben, z. B. aus Molybdän, ist bezüglich einer senkrecht zu den Hauptoberflächen stehenden geometrischen Mittelachse wegen der erforderlichen Drucksymmetrie exakt zentriert und muß in dieser Zuordnung verbleiben, selbst wenn die Anordnung ohne Isoliergehäuse an einen weiterverarbeitenden Betrieb ausgeliefert wird. Ebenso muß diese Bedingung natürlich auch für das mit Isoliergehäuse versehene Halbleiterbauelement erfüllt sein. Das Halbleitermaterial und die Druckkontaktscheiben aus Molybdän oder Wolfram weisen eine stark unterschiedliche Massendichte auf. Daher kann es bei starken Beschleunigungen zu Verschiebungen dieser Teile gegeneinander kommen, insbesondere sind Verschiebungen aufgrund seitlicher Beschleunigung kritisch, zum einen weil die Drucksymmetrie verloren geht, zum anderen weil die Steuerelektrode verschoben werden kann.

Der Erfindung liegt, ausgehend von dem steuerbaren Leistungs-Halbleiterbauelement der eingangs genannten Gattung die Aufgabe zugrunde, einen Beschleunigungsschutz bzw. eine Rüttelfestigkeit bis zu mindestens 5facher Erdbeschleunigung in Richtung der Mittelachse und senkrecht dazu zu erreichen.

Die Lösung dieser Aufgabe besteht darin, daß erfindungsgemäß der Käfig (2) aus zwei übereinanderliegenden, kreisscheibenförmigen Flanschen (4, 5) besteht, die über ein hohlzylindrisches Mittelteil (24) einstückig verbunden sind, daß jeder Flansch (4, 5) innere, polygonale Ausnehmungen (6) besitzt, deren Polygonalflächen (7) mit dem Rand jeweils einer Druckkontaktscheibe (8, 9) in kraftschlüssigem Eingriff steht, und daß der Käfig (2) entlang seinem Durchmesser in zwei Teile geteilt ist.

Mit dieser »Verpackung« ist vorteilhaft eine Schockfestigkeit bis zu 500 g erreichbar. Dabei bleibt die Lage der beiden Druckkontaktkörper zueinander und bezüglich des Silizium-Halbleiterkörpers stabil, was, wie vorbeschrieben, für die Lage der Steuerelektrode und für die Drucksymmetrierung wichtig ist.

Vorzugsweise sind die Ausnehmungen sechseckig und die Teilungslinie verläuft durch zwei Eckpunkte. Auf diese Weise werden für jeden Druckkontaktkörper drei diametral gegenüberliegende, gleichmäßig über den Umfang verteilte, zur Mittelachse achsparallele Paare von Auflagelinien gebildet.

Der Käfig besteht vorzugsweise aus Polysulfon, einem gut isolierenden Material, das zudem leicht und stabil ist und einen günstigen Reibungskoeffizienten mit den bevorzugt aus Molybdän bestehenden Druckkontaktscheiben aufweist.

Zur zusätzlichen Sicherung sind die duktilen Elektroden durch ein Klebemittel, beispielsweise Silikonkautschuk, am Halbleiterkörper fixiert. Das Klebemittel läßt eine unterschiedliche Wärmedehnung zwischen dem Silizium-Halbleiterkörper und den duktilen Elektroden im Betrieb des Leistungs-Halbleiterelementes zu und sichert die duktilen Elektroden gegen Verschiebungen.

Die Erfindung wird nachfolgend anhand eines in der Zeichnung dargestellten Ausführungsbeispiels näher erläutert. Es zeigt

Fig. 1 eine Draufsicht auf ein steuerbares Leistungs-Halbleiterbauelement mit Käfig als Beschleunigungsschutz,

Fig. 2 schematisch einen vertikalen Schnitt entlang der Schnittlinie II-II gemäß Fig. 1,

Fig. 3 eine Draufsicht auf den Käfig,

Fig. 4 einen vertikalen Schnitt des Käfigs entlang der Schnittlinie IV-IV nach Fig. 3 und

Fig. 5 schematisch den Käfig im vertikal geschnittenen Isoliergehäuse.

Für das steuerbare Leistungs-Halbleiterbauelement ist die aus der DE-PS 2 039 806 bekannte Druckkontakttechnik vorgesehen, so daß diese nicht näher beschrieben wird.

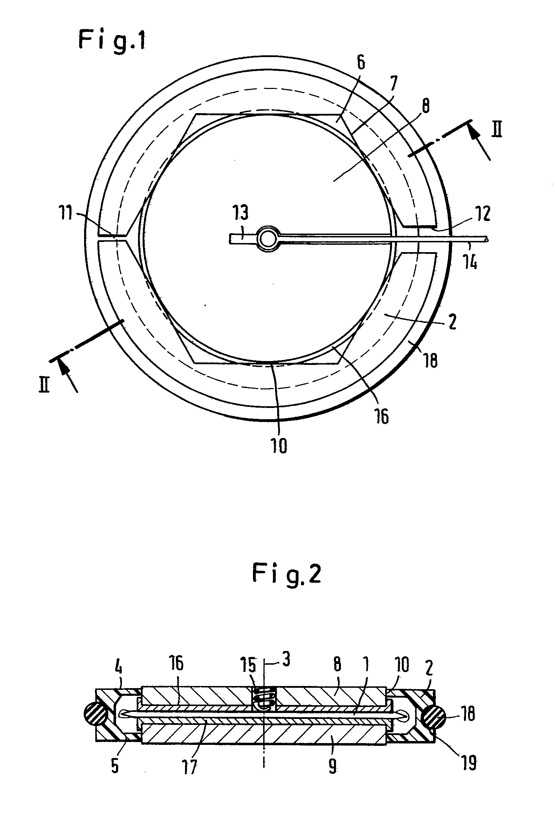

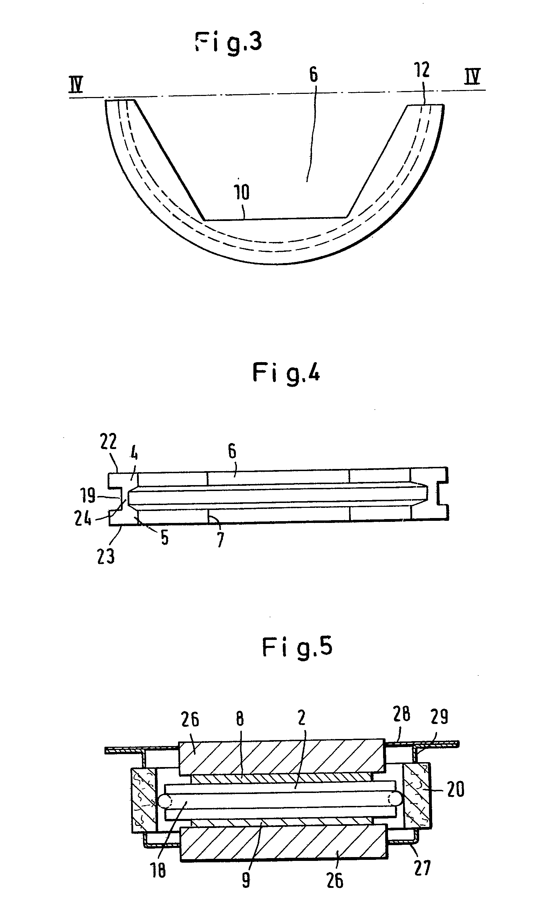

Die Sandwich-Anordnung mit einem eingeschlossenen Siliziumkörper 1 wird von einem kreisringförmigen, entlang seinem Durchmesser in zwei Teile geteilten Käfig 2 mit zwei bezüglich seiner zum Durchmesser vertikalen Mittelachse 3 übereinanderliegenden, durch innere Flansche 4 und 5 begrenzten (Fig. 4), polygonalen, vorzugsweise sechseckigen Ausnehmungen 6 umschlossen. Die Polygonalflächen 7 tangieren Druckkontaktscheiben 8 und 9, vorzugsweise aus Molybdän. Für jede Druckkontaktscheibe 8 und 9 werden dabei drei diametral gegenüberliegende, achsparallel zur Mittelachse 3 verlaufende Auflagelinien 10 gebildet. Der Käfig 2 ist im Bereich zweier diametral gegenüberliegender Eckpunkte der polygonalen Ausnehmungen 6 geteilt — Trennfugen 11 und 12. Die Kontaktscheibe 8 weist einen — in Richtung der Trennfuge 11 und 12 — von ihrem Rand aus über die geometrische Mittelachse 3 hinauslaufenden Schlitz 3 auf, durch den ein Steuerelektrodenanschluß 14 isoliert seitlich herausgeführt ist. Der Steuerelektrodenanschluß 14 kann in an sich bekannter Weise über eine Feder 15 druckkontaktiert sein und ist im Ausführungsbeispiel gemäß Fig. 2 als Zentralgate ausgeführt. Einer der beiden aus der DE-PS 2 039 806 bekannten Silbernäpfe weist hierzu eine Durchführung auf, an die sich der Schlitz 13 in der Kontaktscheibe 8 anschließt.

Die beiden Teile des Käfigs 2 werden randseitig von einem elastischen Spannring 18 umschlossen, der in eine Nut 19 am Außenumfang des Käfigs eingelegt ist. Andere Verspannmöglichkeiten bestehen, z. B. eine Rastverbindung im Bereich der Trennfugen 11 und 12 am Käfig 2 selbst.

Die Fig. 3 und 4 zeigen einen Teil der beiden gleichen Teile des Käfigs 2 gesondert. Jeder Teil ist einstückig und besteht aus einer Deckwand 22 und einer Bodenwand 23, die über ein hohlzylindrisches Mittelteil 24 miteinander verbunden sind.

Die Gesamtanordnung gemäß den Fig. 1 und 2 wird in an sich bekannter Weise in ein vakuumdicht verschließbares Isoliergehäuse eingesetzt. An die Molybdän-Kontaktscheiben 8 und 9 schließen sich Druckkontaktkörper 26 aus Kupfer an, die ihrerseits über metallische Ringteile 27, 28, 29 mit dem Isoliergehäuse 20 aus Keramik verbunden werden (Fig. 5).

## Patentansprüche

1. Steuerbares Leistungs-Halbleiterbauelement mit einem scheibenförmigen Silizium-Körper (1), an dessen Hauptoberflächen sich zwecks Druckkontaktierung je eine duktile Elektrode (16, 17) und nachfolgend je eine Druckkontaktscheibe (8, 9) aus Molybdän oder Wolfram anschließen, mit einem Steuerelektrodenanschluß (14), der isoliert durch eine duktile Elektrode (16) und eine Druckkontaktscheibe (8) geführt ist, und mit einem flachen, kreisringförmigen Käfig (2) aus Isoliermaterial, der Siliziumkörper (1) und Druckkontaktscheiben (8, 9) zentriert, dadurch gekennzeichnet, daß der Käfig (2) aus zwei übereinanderliegenden, kreisscheibenförmigen Flanschen (4, 5) besteht, die über ein hohlzylindrisches Mittelteil (24) einstückig verbunden sind, daß jeder Flansch (4, 5) innere, polygonale Ausnehmungen (6) besitzt, deren Polygonalflächen (7) mit dem Rand jeweils einer Druckkontaktscheibe (8, 9) in kraftschlüssigem Eingriff stehen, und daß der Käfig (2) entlang seinem Durchmesser in zwei Teile geteilt ist.

2. Steuerbares Leistungs-Halbleiterbauelement nach Anspruch 1, dadurch gekennzeichnet, daß die Ausnehmungen (6) sechseckig sind und daß die Teilungslinie des Käfigs (2) durch zwei Eckpunkte der Sechsecke läuft.

3. Steuerbares Leistungs-Halbleiterbauelement nach Anspruch 1 oder 2, dadurch gekennzeichnet, daß der Käfig (2) am Außenrand eine Nut (19) für einen ihn umschließenden Spannring (18) aufweist.

4. Steuerbares Leistungs-Halbleiterbauelement nach Anspruch 1 oder 2, dadurch gekennzeichnet, daß am Käfig (2) Rastverbindungen zum Verbinden der beiden Käfigteile vorgesehen sind.

5. Steuerbares Leistungs-Halbleiterbauelement nach Anspruch 1 oder folgenden, dadurch gekennzeichnet, daß der Käfig (2 aus Polysulfon besteht.

6. Steuerbares Leistungs-Halbleiterbauelement nach Anspruch 1, dadurch gekennzeichnet, daß die duktilen Elektroden (16, 17) napfförmig ausgebildet und über die Druckkontaktscheiben (8, 9) gestülpt und mittels Silikonkautschuk elastisch am Siliziumkörper (1) gehalten sind.

## Claims

1. Controllable power semi-conductor structural component with a disc-shaped silicon body (1) to the main surfaces of which in each case a ductile electrode (16, 17) and subsequently in each case a pressure contact disc (8, 9) of molybdenum or tungsten are connected for the purpose of pressure contact, with a control electrode connection (14) which is led in an insulated manner trhough a ductile electrode (16) and a pressure contact disc (8), and with a flat, circular ring-shaped cage (2) of insulating material which centres the silicon body (1) and pressure contact discs (8, 9), characterized in that the cage (2) consists of two superposed, circular disc-shaped flanges (4, 5) which are connected in one piece via a hollow cylindrical central part (24); in that each flange (4, 5) has inner, polygonal recesses (6), the polygonal surfaces (7) of which are in non-positive engagement with the edge of a pressure contact disc (8, 9) in each case; and in that the cage (2) is divided into two parts along its diameter.

2. Controllable power semi-conductor structural component according to claim 1, characterized in that the recesses (6) are hexagonal and that the dividing line of the cage (2) passes through two corner points of the hexagon.

3. Controllable power semi-conductor structural component according to claim 1 or 2, characterized in that the outer edge of the cage (2) comprises a groove (19) for a clamping ring (18) which encircles the cage (2).

4. Controllable power semi-conductor structural component according to claim 1 or 2, characterized in that on the cage (2) stop connections are provided for connecting the two cage parts.

5. Controllable power semi-conductor structural component according to claim 1 or subsequent claims, characterized in that the cage (2) consists of polysulphone.

6. Controllable power semi-conductor structural component according to claim 1, characterized in that the ductile electrodes (16, 17) are saucer-shaped, are inverted over the pressure contact discs (8, 9) and are held resiliently on the silicon body (1) by means of silicone rubber.

**Revendications**

1. Composant semiconducteur de puissance commandé, comportant un substrat en silicium (1) discoïde, dont chaque face principale est, pour l'établissement d'un contact par pression, suivie d'une électrode ductile (16, 17) puis d'un disque de contact par pression (8, 9) en molybdène ou tungstène, ainsi qu'une borne de gâchette (14), qui traverse avec isolation une électrode ductile (16) et un disque de contact par pression (8), et une cage (2) annulaire plate en matériau isolant, qui centre le substrat en silicium (1) et les disques de contact par pression (8, 9), ledit composant étant caractérisé en ce que la cage (2) est constituée par deux brides (4, 5) annulaires superposées, solidarisées par une pièce centrale cylindrique creuse (24); chaque bride (4, 5) présente des évidements polygonaux intérieurs (6) dont les faces polygonales (7) sont appliquées par action de force sur le bord de chaque'une des disques de contact par pression (8, 9); et la cage (2) est divisée en deux parties suivant son diamètre.

2. Composant semiconducteur de puissance commandé, selon la revendication 1, caractérisé en ce que les évidements (6) sont hexagonaux et la ligne de séparation de la cage (2) passe par deux sommets des hexagones.

3. Composant semiconducteur de puissance commandé selon une des revendications 1 et 2, caractérisé en ce que la cage (2) comporte sur son bord extérieur une gorge (19) servant de logement à une bague de serrage (18) qui l'entoure.

4. Composant semiconducteur de puissance commandé selon une des revendications 1 et 2, caractérisé en ce que des crantages sont prévus sur la cage (2) pour l'assemblage de ses deux parties.

5. Composant semiconducteur de puissance commandé selon une quelconque des revendications 1 à 4, caractérisé en ce que la cage (2) est réalisée en polysulfone.

6. Composant semiconducteur de puissance commandé la revendication 1, caractérisé en ce que les électrodes ductiles (16, 17) sont réalisées sous forme de coupelles, placées sur les disques de contact par pression (8, 9) et fixées élastiquement sur le substrat en silicium (1) par du caoutchouc siliconé.

# Fi g.1

# Fi g.2

Fig.3

Fig.4

Fig.5